# EUROPÄISCHE PATENTSCHRIFT

(11) **EP 2 775 311 B1**
(45) Veröffentlichungstag und Bekanntmachung des Hinweises auf die Patenterteilung: **09.12.2020**
(21) Anmeldenummer: 14155571.4
(22) Anmeldetag: 18.02.2014
(51) Int. Cl.: G01R 15/20, G01R 1/04

(54) **Stromsensor**
Current sensor
Détecteur de courant

(30) Priorität: 08.03.2013 CH 5622013
(43) Veröffentlichungstag der Anmeldung: 10.09.2014
(73) Patentinhaber: Melexis Technologies NV, 3980 Tessenderlo (BE)
(72) Erfinder: Racz, Robert, 6300 Zug (CH); Ackermann, Mathieu, 1006 Lausanne (CH); Chen, Jian, Heist op den Berg 2220 (BE)
(74) Vertreter: Falk, Urs

(56) Entgegenhaltungen:
- EP-A1- 2 295 993
- EP-A2- 2 437 072
- US-A1- 2007 170 533
- US-A1- 2012 146 164
- US-A1- 2013 020 660

## Beschreibung

Die Erfindung betrifft einen Stromsensor, insbesondere einen in einem IC Gehäuse (IC = Integrated Circuit) verpackten Stromsensor, bei dem der Stromleiter durch das Gehäuse führt.

Stromsensoren gibt es in vielen Ausführungen und Varianten. Stromsensoren, die das vom Strom erzeugte Magnetfeld erfassen, in einem herkömmlichen IC Gehäuse verpackt sind und bei denen der Stromleiter, durch den der zu messende Strom fliesst, durch das Gehäuse geführt ist, sind beispielsweise bekannt aus EP 1443332, WO 2005026749, WO 2006130393 und DE 102009054892. Solche Stromsensoren enthalten einen Stromleiter, der als ein Teil des Leadframes ausgebildet ist, das für die Montage und die Herstellung der elektrischen Anschlüsse verwendet wird, und einen auf dem Leadframe montierten Halbleiterchip, der mindestens einen Magnetfeldsensor und die für dessen Betrieb und die Verarbeitung seines Ausgangssignals nötige Elektronik aufweist.

Weil der durch das Gehäuse geführte Stromleiter einen relativ kleinen Querschnitt hat und im Bereich der Magnetfeldsensoren einen nochmals reduzierten Querschnitt aufweist, um dort die Stromdichte und damit das Magnetfeld lokal zu erhöhen, führt die durch die Verlustleistung im Stromleiter entstehende Wärme zu einer Erwärmung des Stromsensors, die unerwünschte Driftschwankungen der Magnetfeldsensoren bewirkt. Der Stromleiter und die im Halbleiterchip integrierte Elektronik müssen elektrisch voneinander isoliert sein, wobei von der Isolation eine vorbestimmte Spannungsfestigkeit verlangt wird, die typischerweise 2 bis 4 kV beträgt.

Der Erfindung liegt die Aufgabe zugrunde, einen Stromsensor für relativ hohen Nennstrom und hohe Spannungsfestigkeit zu entwickeln, der wenig Platz beansprucht und kostengünstig herstellbar ist.

Die genannte Aufgabe wird erfindungsgemäss gelöst durch die Merkmale des Anspruchs 1. Vorteilhafte Ausgestaltungen ergeben sich aus den abhängigen Ansprüchen.

Ein erfindungsgemässer Stromsensor umfasst ein Gehäuse aus Kunststoff, einen Stromleiter mit angeformten ersten und zweiten elektrischen Anschlüssen, durch die ein zu messender Strom zu- und abgeführt wird, dritte elektrische Anschlüsse, und einen Halbleiterchip mit einer aktiven Oberfläche mit wenigstens einem Magnetfeldsensor, der empfindlich ist auf eine senkrecht zur aktiven Oberfläche des Halbleiterchips verlaufende Komponente des Magnetfeldes, das von dem durch den Stromleiter fliessenden Strom erzeugt wird, wobei die ersten und zweiten elektrischen Anschlüsse an einer ersten Seite des Gehäuses und die dritten elektrischen Anschlüsse an einer der ersten Seite gegenüberliegenden Seite des Gehäuses angeordnet sind, wobei die aktive Oberfläche des Halbleiterchips dem Stromleiter zugewandt und elektrische Anschlussflächen des Halbleiterchips über erste Bumps mit den dritten elektrischen Anschlüssen verbunden sind, und wobei der Halbleiterchip zweite Bumps aufweist, die von der aktiven Oberfläche des Halbleiterchips durch eine Isolationsschicht galvanisch getrennt sind und auf dem Stromleiter oder auf an dem Stromleiter angeformten Fortsätzen aufliegen.

Bevorzugt sind die über dem Halbleiterchip liegenden Enden der dritten elektrischen Anschlüsse im Wesentlichen entlang einer Linie angeordnet sind und eine benachbarte Kante des Stromleiters verläuft parallel zur Linie, so dass alle dritten elektrischen Anschlüsse annähernd im gleichen Abstand vom Stromleiter entfernt sind.

Bevorzugt weist der Stromleiter wenigstens zwei Fortsätze auf, die sich bis an den Rand des Gehäuses erstrecken und dort freiliegen.

Bevorzugt weist die Isolationsschicht eine Schicht aus organischem Material auf. Das organische Material kann Polyimid sein.

Bevorzugt sind zwischen der Oberfläche des Bulk-Materials des Halbleiterchips und den zweiten Bumps keine elektrisch leitenden Strukturen aus einer für die Herstellung von elektrischen Verbindungen vorhandenen Metallisierungsschicht vorhanden.

Die Erfindung wird nachfolgend anhand der Zeichnung näher erläutert.
- Fig. 1: zeigt in Aufsicht ein erstes Ausführungsbeispiel eines erfindungsgemässen Stromsensors, und
- Fig. 2: zeigt im Schnitt einen Halbleiterchip mit Bumps,
- Fig. 3: zeigt in Aufsicht ein zweites Ausführungsbeispiel eines erfindungsgemässen Stromsensors,
- Fig. 4, 5: zeigen in Aufsicht und von unten ein drittes Ausführungsbeispiel eines erfindungsgemässen Stromsensors,
- Fig. 6, 7: zeigen in Aufsicht weitere Ausführungsbeispiele von erfindungsgemässen Stromsensoren, und
- Fig. 8, 9: zeigen im Schnitt weitere Ausführungsbeispiele von erfindungsgemässen Stromsensoren.

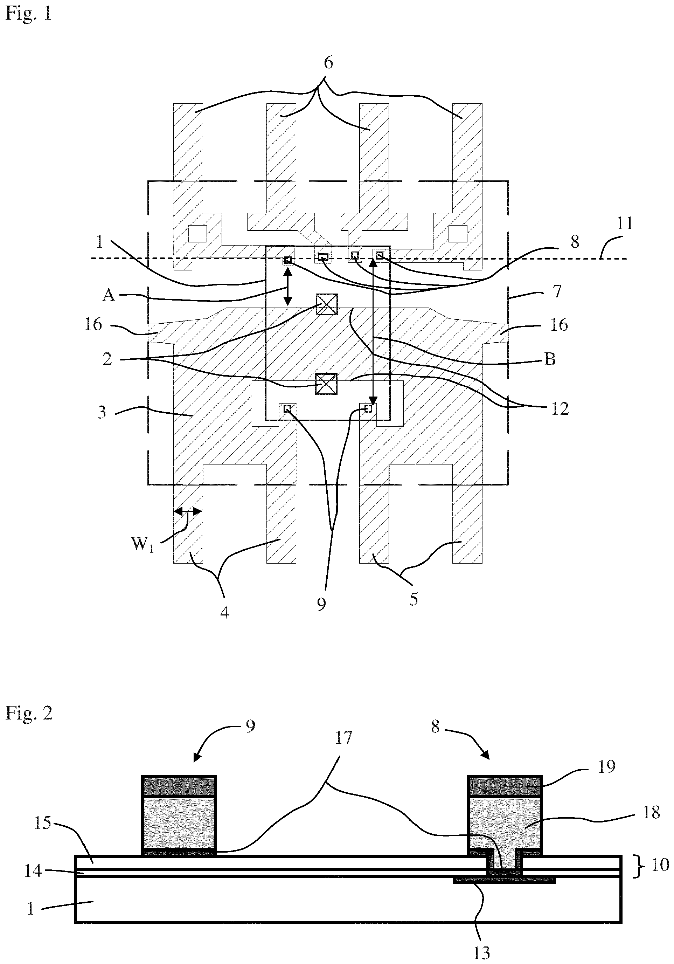

Die Fig. 1 zeigt in Aufsicht einen erfindungsgemässen Stromsensor. Der Stromsensor umfasst einen Halbleiterchip 1 mit wenigstens einem Magnetfeldsensor 2 und elektronischen Schaltkreisen für den Betrieb des wenigstens einen Magnetfeldsensors 2 und die Verarbeitung des von dem mindestens einen Magnetfeldsensor 2 gelieferten Messsignals. Der Stromsensor umfasst weiter einen flachen Stromleiter 3, dessen Enden als erste elektrische Anschlüsse 4 und zweite elektrische Anschlüsse 5 ausgeführt sind, und dritte elektrische Anschlüsse 6. Die dritten elektrischen Anschlüsse 6 dienen zur Versorgung der elektronischen Schaltkreise mit elektrischer Energie und für die Ausgabe eines Ausgangssignals. Ihre Anzahl beträgt mindestens drei, im Beispiel vier. Der Stromleiter 3 und der IIalbleiterchip 1 sind in ein IC Gehäuse 7 verpackt, wobei die elektrischen Anschlüsse 4, 5 und 6 entweder als IC Beinchen aus dem Gehäuse 7 herausragen (z.B. bei einem SOIC-8 oder SOIC-16 Gehäuse) oder an der Unterseite und/oder Seitenwänden des Gehäuses 7 freiliegen (z.B. bei einem QFN Gehäuse). Der Stromleiter 3 und die elektrischen Anschlüsse 4, 5 und 6 sind Teile eines so genannten Leadframes, das für die Herstellung verwendet wurde. Die elektrischen Anschlüsse 4 und 5 sind auf einer ersten Seite des Gehäuses 7, die elektrischen Anschlüsse 6 sind auf einer zweiten, der ersten gegenüberliegenden Seite des Gehäuses 7 angeordnet. Der Halbleiterchip 1 ist als Flipchip montiert, d.h. seine aktive Oberfläche, in die der mindestens eine Magnetfeldsensor 2 und die elektronischen Schaltkreise integriert sind, ist dem Stromleiter 3 zugewandt und so genannte erste "Bumps" 8 stellen die elektrischen Verbindungen zwischen dem Halbleiterchip 1 und den elektrischen Anschlüssen 6 her. Zwischen dem Stromleiter 3 und dem Halbleiterchip 1 sind zusätzlich zweite Bumps 9 angeordnet, die jedoch keine elektrische Verbindung zwischen dem Halbleiterchip 1 und dem Stromleiter 3 herstellen, sondern vom Halbleiterchip 1 durch eine Isolationsschicht getrennt sind, wie dies im Detail in der Fig. 2 gezeigt ist. Die Isolationsschicht kann aus einer einzigen elektrisch nicht leitenden Schicht, z.B. einer Passivierungsschicht, oder aus zwei oder mehr übereinander liegenden, elektrisch nicht leitenden, d.h. elektrisch isolierenden, Schichten bestehen.

Der Stromleiter 3 ist im wesentlichen U-förmig, wobei das U aus drei Abschnitten gebildet ist, nämlich einem ersten Abschnitt, der die ersten elektrischen Anschlüsse 4 umfasst, einem zweiten länglichen Abschnitt mit parallelen Kanten 12 und einem dritten Abschnitt, der die zweiten elektrischen Anschlüsse 5 umfasst. Bei dem in der Fig. 1 gezeigten Ausführungsbeispiel des erfindungsgemässen Stromsensors hat der Stromleiter 3 zwei erste elektrische Anschlüsse 4 und zwei zweite elektrische Anschlüsse 5, die als Anschlussbeinchen aus dem Gehäuse 7 herausragen. Die aus dem Gehäuse 7 herausragenden Enden der Anschlussbeinchen der ersten elektrischen Anschlüsse 4 können ihrerseits miteinander verbunden sein, d.h. als so genannte fused leads ausgeführt sein, ebenso die aus dem Gehäuse 7 herausragenden Enden der Anschlussbeinchen der zweiten elektrischen Anschlüsse 5. Bevorzugt sind zwei Magnetfeldsensoren 2 oder Cluster von Magnetfeldsensoren vorgesehen, die beidseitig des mittleren Abschnitts im Bereich der Kanten 12 des Stromleiters 3 angeordnet sind. Da das Magnetfeld, das von dem durch den Stromleiter 3 fliessenden Strom erzeugt wird, am Ort der beiden Magnetfeldsensoren 2 in entgegengesetzte Richtungen zeigt, werden die Ausgangssignale der beiden Magnetfeldsensoren 2 voneinander subtrahiert (Differenzschaltung). Auf diese Weise kann der Einfluss eines homogenen externen Störfeldes eliminiert werden. Jeder Magnetfeldsensor 2 ist bevorzugt ein Hallelement oder ein Cluster von Hallelementen.

Die ersten Bumps 8 und die zweiten Bumps 9 werden auf den Halbleiterchip 1 aufgebracht, wobei die ersten Bumps 8 elektrische Anschlussflächen 13 (Fig. 2) des Halbleiterchips 1 kontaktieren, während die zweiten Bumps 9 von der aktiven Oberfläche des Halbleiterchips 1 durch die Isolationsschicht galvanisch getrennt sind. Bei der Herstellung des Stromsensors wird der Halbleiterchip 1 als Flipchip auf dem Leadframe platziert. Die ersten Bumps 8 liegen auf den elektrischen Anschlüssen 6 auf und stellen die elektrischen Verbindungen zwischen dem Halbleiterchip 1 und den elektrischen Anschlüssen 6 her. Die zweiten Bumps 9 liegen auf dem Stromleiter 3 auf. Ihre Aufgabe ist, den Halbleiterchip 1 zu stützen, damit die aktive Oberfläche des Halbleiterchips 1 parallel zur Oberfläche des Stromleiters 3 ausgerichtet ist und dies auch während des Verpackens im Gehäuse 7 bleibt, das durch Vergiessen in einer Form erfolgt. Die Isolationsschicht bewirkt, dass die zweiten Bumps 9 und somit auch der Stromleiter 3 galvanisch vom Halbleiterchip 1 getrennt sind.

Der erfindungsgemässe Stromsensor ist dahingehend ausgelegt, bei einem vorgegebenen Standard IC Gehäuse einerseits eine hohe Spannungsfestigkeit und andererseits einen möglichst hohen Nennstrom zu erreichen. Die beiden Ziele werden dadurch erreicht, dass die unter dem Flipchip liegenden Enden der dritten elektrischen Anschlüsse 6 im Wesentlichen entlang einer Linie 11 angeordnet sind, die parallel zu der benachbarten Kante 12 des mittleren Abschnitts des Stromleiters 3 verläuft, so dass alle dritten elektrischen Anschlüsse 6 annähernd im gleichen Abstand A vom Stromleiter 3 entfernt sind. Der Abstand A ist so gross bemessen, dass die geforderte Spannungsfestigkeit gegeben ist. Die Anordnung der dritten elektrischen Anschlüsse 6 entlang der Linie 11 ermöglicht es, dass der Stromleiter 3 die innerhalb des Gehäuses 7 insgesamt zur Verfügung stehende Fläche weit gehend ausfüllen kann, nämlich abgesehen von Ausnehmungen und/oder Löchern im Stromleiter 3, die zur Vermeidung einer Delamination von Stromleiter 3 und Gehäuse 7 nötig sind. Mit anderen Worten, der Stromleiter 3 hat überall eine relativ grosse Breite, was seinen elektrischen Widerstand auf einen minimal möglichen Wert reduziert und damit dafür sorgt, einerseits die Verlustleistung bei vorgegebenen Gehäuseabmessungen zu minimieren und andererseits die entstehende Wärme effizient an die Umgebung abzuführen.

Die ersten Bumps 8 und die zweiten Bumps 9 liegen in einem Abstand B auseinander. Sie sind bevorzugt in der Nähe von einander entgegengesetzten Kanten des Halbleiterchips 1 angeordnet, so dass der Abstand B maximal ist. Der Abstand B kann auch kleiner sein. Die Stützfunktion der zweiten Bumps 9 ist üblicherweise erfüllt, wenn B > A ist, da der Abstand A typischerweise wenigstens einen Viertel bis einen Drittel der Seitenlänge des Halbleiterchips 1 beträgt. Vorzugsweise sind zwei zweite Bumps 9 vorhanden, es kann aber auch nur ein einziger zweiter Bump 9 vorgesehen sein, der dann etwa auf der Mittelachse des Halbleiterchips 1 anzuordnen ist.

Die aktive Oberfläche des Halbleiterchips 1 ist, mit Ausnahme der freiliegenden Anschlussflächen 13, mit einer Passivierungsschicht 14 bedeckt, die beispielsweise aus Siliziumdioxid oder Siliziumnitrid besteht. Die Passivierungsschicht 14 ist elektrisch nicht leitend. Auf die relativ dünne Passivierungsschicht 14 ist eine weitere elektrisch nicht leitende Schicht 15 aufgebracht, deren Dicke so gross bemessen ist, dass die zwischen dem Stromleiter 3 und dem Halbleiterchip 1 geforderte Spannungsfestigkeit erreicht wird. Als Material für die elektrisch nicht leitende Schicht 15 eignet sich insbesondere ein organisches Material. Ein Beispiel für ein bevorzugtes organisches Material ist Polyimid. Die Dicke der elektrisch nicht leitenden Schicht 15 liegt typischerweise in einem Bereich von 10-20 µm, sie kann aber auch höhere Werte von 30 oder sogar 40 µm erreichen. Die Passivierungsschicht 14 und die elektrisch nicht leitende Schicht 15 bilden zusammen eine Zweischicht Isolationsschicht, die in Fig. 2 gezeigt und dort mit dem Bezugszeichen 10 bezeichnet ist.

Der Stromleiter 3 hat einen elektrischen Widerstand, weshalb der durch den Stromleiter 3 fliessende Strom Wärme erzeugt, die an die Umgebung abgeführt werden muss. Um die von dem maximal zugelassenen Strom erzeugte Wärme zu minimieren, ist der Stromleiter 3 auf seiner ganzen Länge so breit als möglich auszuführen. Andererseits ist die Breite des Stromleiters 3 im Bereich des wenigstens einen Magnetfeldsensors 2 möglichst schmal auszuführen, um das von dem durch den Stromleiter 3 fliessenden Strom erzeugte Magnetfeld zu maximieren. Die Dicke des Stromleiters 3 ist einheitlich, weil sie durch die Dicke des Leadframes vorgegeben ist. Die Geometrie der Anschlussbeinchen, d.h. hier insbesondere ihre Breite W₁, ist durch Normen vorgegeben. Die Breite des Stromleiters 3 ist mit Vorteil überall breiter als die vorgegebene Breite W₁ der Anschlussbeinchen. Der Stromleiter 3 kann bei Bedarf mit zusätzlichen Löchern oder Schlitzen ausgebildet werden, um eine Delamination vom Gehäuse 7 auszuschliessen.

Zur Erhöhung der mechanischen Stabilität ist der Stromleiter 3 fakultativ mit Fortsätzen 16 ausgebildet, die ursprünglich mit dem Rahmen des Leadframes verbunden sind, am Ende des Produktionsprozesses jedoch zusammen mit den elektrischen Anschlüssen 4, 5 und 6 vom Rahmen des Leadframes abgetrennt werden. Die Fortsätze 16 liegen daher am Rand des Gehäuses 7 frei. Im Beispiel sind zwei Fortsätze 16 vorgesehen, die in der Verlängerung des mittleren Abschnitts des Stromleiters 3 angeordnet sind.

Die Fig. 2 zeigt in nicht massstäblicher Darstellung im Schnitt den Halbleiterchip 1 mit einem ersten Bump 8 und einem zweiten Bump 9. Die Passivierungsschicht 14 und die weitere elektrisch nicht-leitende Schicht 15, die zusammen die Isolationsschicht 10 bilden, bedecken die aktive Oberfläche des Halbleiterchips 1 mit Ausnahme derjenigen Stellen, wo die ersten Bumps 8 die elektrischen Anschlussflächen 13 des Halbleiterchips 1 kontaktieren sollen. Die Bumps 8 und 9 sind in einer Standardtechnologie gefertigt, sie umfassen beispielsweise eine Metallschicht 17 (engl. metal via genannt), eine Kupferschicht 18 und eine Lotschicht 19. Die Bumps 8 und 9 können auch aus anderen Materialien hergestellt werden. Die Metallschicht 17 kann auch eine Schichtfolge aus zwei oder mehr Materialien sein, damit die Metallschicht 17 einerseits gut haftet und andererseits als Seedlayer für das galvanische Auftragen der Kupferschicht 18 dienen kann. Bei der Montage des Flipchips auf dem Leadframe werden die Bumps 8 und 9 aufgeschmolzen und mit den dritten elektrischen Anschlüssen 6 bzw. dem Stromleiter 3 verlötet. Die ersten Bumps 8 stellen die elektrischen Verbindungen zu den elektrischen Anschlussflächen 13 auf dem Halbleiterchip 1 her, während bei den zweiten Bumps 9 die Isolationsschicht 10 eine elektrische Verbindung zwischen dem Stromleiter 3 und dem Halbleiterchip 1 verhindert.

Vorteilhafterweise befinden sich zwischen der Oberfläche des Bulk-Materials des Halbleiterchips 1 und den zweiten Bumps 9 keine elektrisch leitenden Strukturen aus einer für die Herstellung der elektrischen Verbindungen vorhandenen Metallisierungsschicht wie zum Beispiel die Metallisierungsschicht der Anschlussfläche 13, um die Spannungsfestigkeit weiter zu erhöhen.

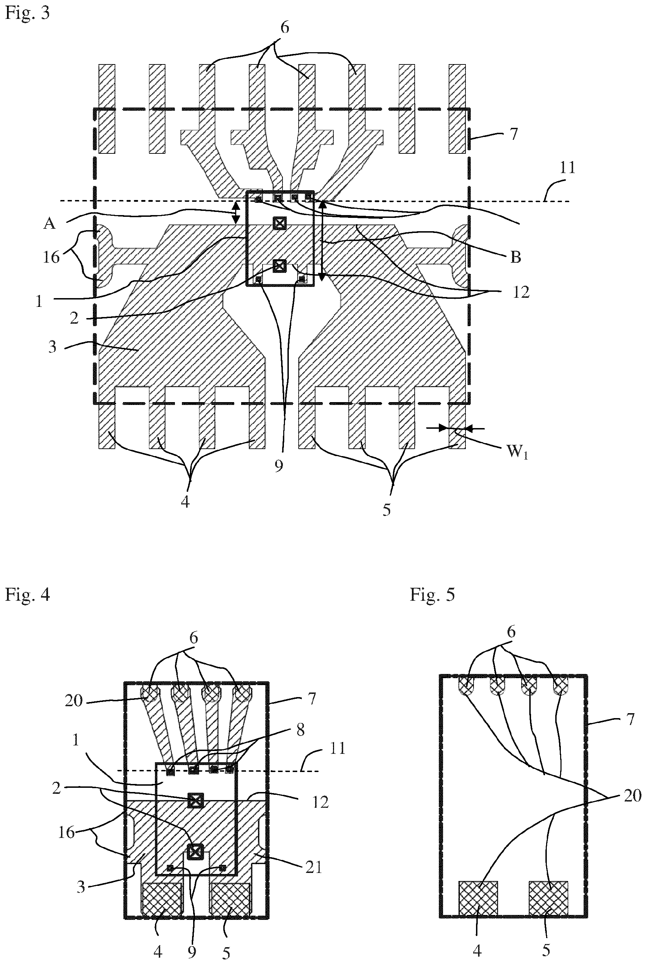

Die Fig. 3 zeigt in Aufsicht ein zweites Ausführungsbeispiel eines erfindungsgemässen Stromsensors, der ausgelegt ist für ein SOIC-16 Gehäuse. Bei dem ersten und dem zweiten Ausführungsbeispiel weist der Stromleiter 3 zwei angeformte Fortsätze auf, oberhalb derer die zweiten Bumps 9 angeordnet sind. Diese Fortsätze ermöglichen es, einerseits die ersten Bumps 8 und zweiten Bumps 9 je nahe einer Kante des Halbleiterchips 1 anzuordnen und andererseits den Halbleiterchip 1 in Bezug auf die Längsachse des Stromleiters 3 in seinem mittleren Abschnitt annähernd symmetrisch anzuordnen. Zusammen mit dem relativ breit ausgeführten mittleren Abschnitt des Stromleiters 3 führt dies dazu, dass der Stromleiter 3 in Bezug auf den Halbleiterchip 1 eine relativ grossflächige Wärmequelle ist, so dass im Bereich der Magnetfeldsensoren 2 und der für den Betrieb der Magnetfeldsensoren 2 nötigen analogen elektronischen Schaltkreise kein Temperaturgradient entsteht.

Die Fig. 4 zeigt in Aufsicht ein drittes Ausführungsbeispiel eines erfindungsgemässen Stromsensors, der ausgelegt und optimiert ist für ein QFN Gehäuse, die Fig. 5 zeigt den Stromsensor von unten, d.h. seine Unterseite. Das Leadframe enthält erste Bereiche 20 mit seiner Nominaldicke und zweite Bereiche 21 mit reduzierter Dicke. Die ersten Bereiche 20 liegen an der Unterseite des Gehäuses 7 frei, die zweiten Bereiche 21 befinden sich im Inneren des Gehäuses 7. Die ersten Bereiche 20 entsprechen den Anschlüssen des Stromsensors, über die der Stromsensor mit einer Leiterplatte verbunden wird. Zur Erhöhung der mechanischen Stabilität ist der Stromleiter 3 auch bei diesem Ausführungsbeispiel mit Vorteil mit den Fortsätzen 16 ausgebildet, die ursprünglich mit dem Rahmen des Leadframes verbunden sind, am Ende des Produktionsprozesses jedoch zusammen mit den elektrischen Anschlüssen 4, 5 und 6 vom Rahmen des Leadframes abgetrennt werden. Die Fortsätze 16 liegen am Rand des Gehäuses 7 frei. Bei diesem Ausführungsbeispiel sind in der Verlängerung des mittleren Abschnitts des Stromleiters 3 auf beiden Seiten je zwei Fortsätze 16 vorgesehen.

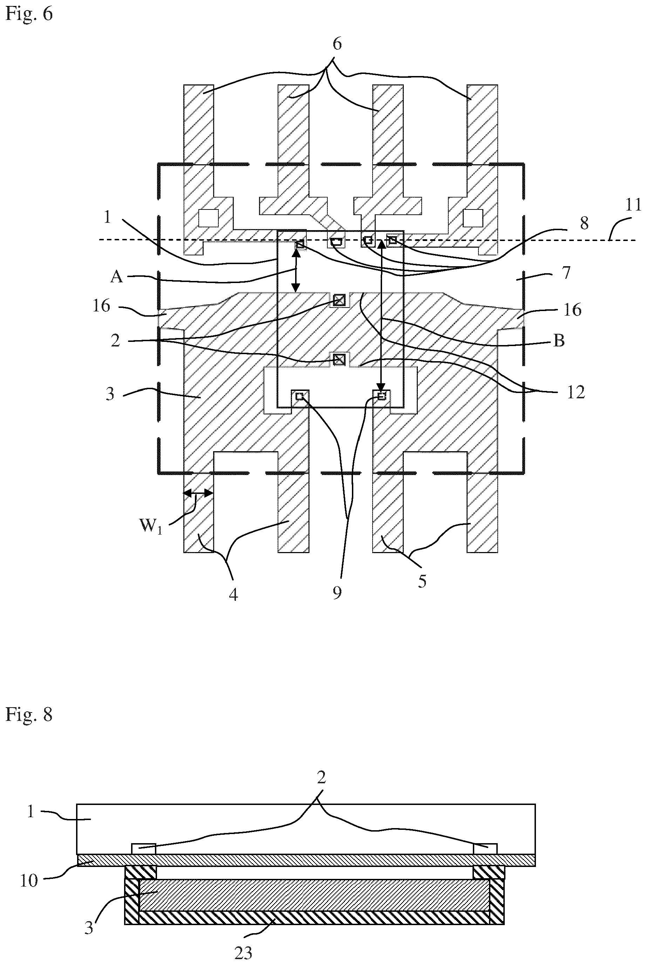

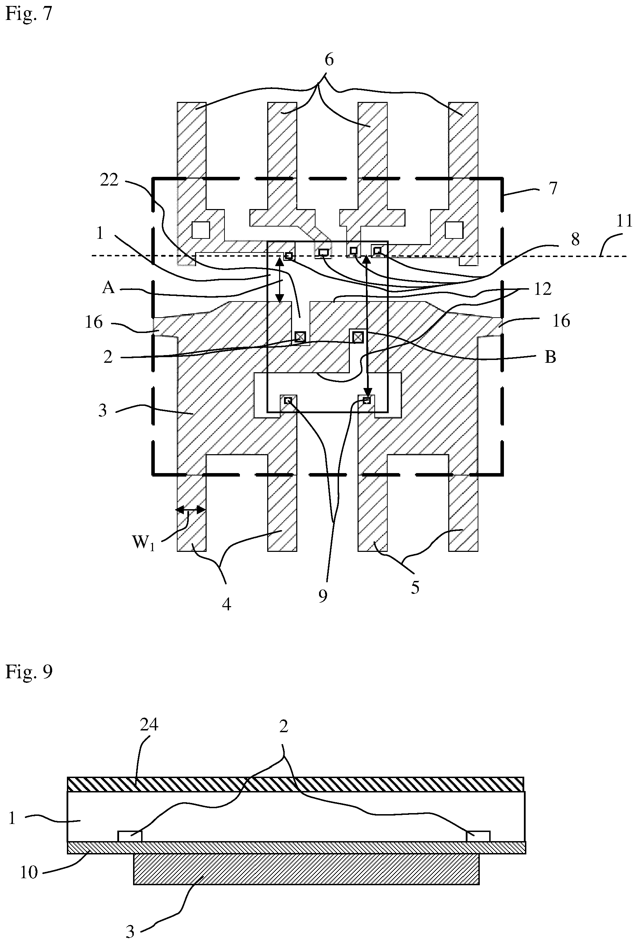

Die Fig. 6 zeigt eine Variante des Stromsensors des zweiten Ausführungsbeispiels, bei dem der mittlere Abschnitt des Stromleiters 3 im Bereich der beiden Magnetfeldsensoren 2 verschmalert und der Abstand zwischen den beiden Magnetfeldsensoren verkleinert 2 ist. Die Fig. 7 zeigt eine weitere Variante des Stromsensors des zweiten Ausführungsbeispiels, bei dem der mittlere Abschnitt des Stromleiters 3 im Bereich der beiden Magnetfeldsensoren 2 durch zwei Schlitze 22 "S-förmig" ausgebildet ist. Die Schlitze 22 sind so angeordnet, dass der Stromleiter 3 im Bereich der beiden Magnetfeldsensoren 2 verschmalert ist und die Magnetfeldsensoren 2 U-förmig umschliesst. Bei diesen beiden Varianten wird gegenüber dem in der Fig. 4 gezeigten Stromsensor eine Erhöhung der Empfindlichkeit zu Lasten eines tieferen Nennstroms erreicht.

Die Fig. 8 zeigt im Querschnitt, allerdings nicht massstäblich, eine Ausführung eines erfindungsgemässen Stromsensors, bei der der Stromleiter 3 auf drei Seiten vollständig und auf der dem Halbleiterchip 1 gegenüberliegenden vierten Seite nur in Randbereichen mit einer ferromagnetischen Schicht 23 bedeckt ist. Die ferromagnetische Schicht 23 erstreckt sich so weit, dass sie die Magnetfeldsensoren 2 überdeckt. Die Dicke der ferromagnetischen Schicht 23 beträgt etwa 50 bis 100 µm, oder auch mehr. Sie stellt ein magnetisches Joch dar, das das von dem durch den Stromleiter 3 fliessenden Strom erzeugte Magnetfeld am Ort der Magnetfeldsensoren 2 verstärkt. Die ferromagnetische Schicht 23 wird beispielsweise durch Electroplating auf den Stromleiter 3 aufgebracht.

Die Fig. 9 zeigt im Querschnitt, allerdings nicht massstäblich, eine Ausführung eines erfindungsgemässen Stromsensors, bei der auf der Rückseite des Halbleiterchips 1 eine ferromagnetische Schicht 24 aufgebracht ist. Die ferromagnetische Schicht 24 senkt einerseits den magnetischen Widerstand für das vom Stromleiter 3 erzeugte Magnetfeld und verstärkt dieses. Zudem wirkt sie als Abschirmung für äussere Magnetfelder, die parallel zu der vom Halbleiterchip 1 aufgespannten Ebene verlaufen.

Die Ausführungsbeispiele der Fig. 8 und Fig. 9 können auch kombiniert werden, so dass beide ferromagnetischen Schichten 23 und 24 vorhanden sind.

Die erfindungsgemässe Ausgestaltung der Stromsensoren erfüllt beispielsweise die Anforderungen der Norm UL 60950-1.

## Patentansprüche

1. Stromsensor, umfassend
ein Gehäuse (7) aus Kunststoff,
einen Stromleiter (3) mit angeformten ersten und zweiten elektrischen Anschlüssen (4, 5), durch die ein zu messender Strom zu- und abgeführt wird,
dritte elektrische Anschlüsse (6),
einen Halbleiterchip (1) mit einer aktiven Oberfläche mit wenigstens einem Magnetfeldsensor (2), der empfindlich ist auf eine senkrecht zur aktiven Oberfläche des Halbleiterchips (1) verlaufende Komponente des Magnetfeldes, das von dem durch den Stromleiter (3) fliessenden Strom erzeugt wird,
wobei die ersten und zweiten elektrischen Anschlüsse (4, 5) an einer ersten Seite des Gehäuses (7) und die dritten elektrischen Anschlüsse (6) an einer der ersten Seite gegenüberliegenden Seite des Gehäuses (7) angeordnet sind,
wobei die aktive Oberfläche des Halbleiterchips (1) dem Stromleiter (3) zugewandt und elektrische Anschlussflächen (13) des Halbleiterchips (1) über erste Bumps (8) mit den dritten elektrischen Anschlüssen (6) verbunden sind,
**dadurch gekennzeichnet, dass**
der Stromleiter (3) U-förmig ist, wobei das U aus drei Abschnitten gebildet ist, nämlich einem ersten Abschnitt, der die ersten elektrischen Anschlüsse (4) umfasst, einem zweiten länglichen Abschnitt mit parallelen Kanten (12) und einem dritten Abschnitt, der die zweiten elektrischen Anschlüsse (5) umfasst,
wobei der Stromleiter (3) überall eine relativ grosse Breite hat, um seinen elektrischen Widerstand auf einen minimal möglichen Wert zu reduzieren,
dass der Halbleiterchip (1) in Bezug auf eine Längsachse des Stromleiters (3) in dem zweiten Abschnitt annähernd symmetrisch angeordnet ist, und
dass der Halbleiterchip (1) zweite Bumps (9) aufweist, die von der aktiven Oberfläche des Halbleiterchips (1) durch eine Isolationsschicht (10) galvanisch getrennt sind und auf dem Stromleiter (3) oder an dem Stromleiter (3) angeformten Fortsätzen aufliegen.

2. Stromsensor nach Anspruch 1, **dadurch gekennzeichnet, dass** die über dem Halbleiterchip (1) liegenden Enden der dritten elektrischen Anschlüsse (6) im Wesentlichen entlang einer Linie (11) angeordnet sind und dass eine benachbarte Kante (12) des Stromleiters (3) parallel zur Linie (11) verläuft, so dass alle dritten elektrischen Anschlüsse (6) annähernd im gleichen Abstand (A) vom Stromleiter (3) entfernt sind.

3. Stromsensor nach Anspruch 1 oder 2, **dadurch gekennzeichnet, dass** der Stromleiter (3) wenigstens zwei Fortsätze (16) aufweist, die sich bis an den Rand des Gehäuses (7) erstrecken und dort freiliegen.

4. Stromsensor nach einem der Ansprüche 1 bis 3, **dadurch gekennzeichnet, dass** die P489EP, September 2017
Isolationsschicht (10) eine Schicht aus organischem Material aufweist.

5. Stromsensor nach Anspruch 4, **dadurch gekennzeichnet, dass** das organische Material Polyimid ist.

6. Stromsensor nach einem der Ansprüche 1 bis 5, **dadurch gekennzeichnet, dass** zwischen der Oberfläche des Bulk-Materials des Halbleiterchips (1) und den zweiten Bumps (9) keine elektrisch leitenden Strukturen aus einer für die Herstellung von elektrischen Verbindungen vorhandenen Metallisierungsschicht vorhanden sind.

7. Stromsensor nach einem der Ansprüche 1 bis 6, **dadurch gekennzeichnet, dass** der Stromleiter (3) auf drei Seiten vollständig und auf der dem Halbleiterchip (1) gegenüberliegenden Seite in Randbereichen mit einer ferromagnetischen Schicht (23) bedeckt ist.

8. Stromsensor nach einem der Ansprüche 1 bis 7, **dadurch gekennzeichnet, dass** der Halbleiterchip (1) auf der dem Stromleiter (3) abgewandten Seite mit einer ferromagnetischen Schicht (24) ist.

9. Stromsensor nach einem der Ansprüche 1 bis 8, **dadurch gekennzeichnet, dass** das Gehäuse (7) ein QFN Gehäuse ist und dass an der Unterseite des QFN Gehäuses nur die elektrischen Anschlüsse des Stromsensors freiliegen.

10. Stromsensor nach einem der Ansprüche 1 bis 9, **dadurch gekennzeichnet, dass** der wenigstens eine Magnetfeldsensor (2) zwei Magnetfeldsensoren oder Cluster von Magnetfeldsensoren umfasst, die im Bereich eines mittleren Abschnitts des Stromleiters (3) bei verschiedenen Kanten des Stromleiters (3) angeordnet sind, so dass das Magnetfeld, das von dem durch den Stromleiter (3) fliessenden Strom erzeugt wird, am Ort der beiden Magnetfeldsensoren (2) in entgegengesetzte Richtungen zeigt.

## Claims

1. Current sensor, comprising
a housing (7) of plastic,
a current conductor (3) with integrally shaped first and second electrical terminals (4, 5), through which a current to be measured is supplied and discharged,
third electrical terminals (6),
a semiconductor chip (1) having an active surface with at least one magnetic field sensor (2), which is sensitive to a component of the magnetic field generated by the current flowing through the current conductor (3) running perpendicularly to the active surface of the semiconductor chip (1),
wherein the first and second electrical terminals (4, 5) are arranged at a first side of the housing (7) and the third electrical terminals (6) are arranged at a side of the housing (7) opposite to the first side,
wherein the active surface of the semiconductor chip (1) faces the current conductor (3) and electrical connection surfaces (13) of the semiconductor chip (1) are connected with the third electrical terminals (6) by first bumps (8),
**characterized in that**
the current conductor (3) is U-shaped wherein the U is formed from three sections, namely a first section which comprises the first electrical terminals (4), a second elongated section with parallel edges (12), and a third section which comprises the second electrical terminals (5), wherein the current conductor (3) has everywhere a relatively large width to reduce its electrical resistance to a lowest possible value,
**in that** the semiconductor chip (1) is arranged approximately symmetrically with respect to a longitudinal axis of the current conductor (3) in the second section, and
**in that** the semiconductor chip (1) has second bumps (9) which are electrically isolated from the active surface of the semiconductor chip (1) by an insulation layer (10) and rest on the current conductor (3) or on projections formed integrally to the current conductor (3).

2. Current sensor according to claim 1, **characterized in that** the ends of the third electrical terminals (6) situated above the semiconductor chip (1) are substantially arranged along a line (11) and **in that** an adjacent edge (12) of the current conductor (3) extends parallel to the line (11), so that all third electrical terminals (6) are remote from the current conductor (3) at approximately the same distance (A).

3. Current sensor according to claim 1 or 2, **characterized in that** the current conductor (3) comprises at least two projections (16) which extend to the edge of the housing (7) and are exposed there.

4. Current sensor according to any of claims 1 to 3, **characterized in that** the isolation layer (10) comprises a layer of organic material.

5. Current sensor according to claim 4, **characterized in that** the organic material is polyimide.

6. Current sensor according to any of claims 1 to 5, **characterized in that** no electrically conductive structures used for the production of electrical connections are present between the surface of the bulk material of the semiconductor chip (1) and the second bumps (9).

7. Current sensor according to any of claims 1 to 6, **characterized in that** the current conductor (3) is covered on three sides completely and on the side opposite the semiconductor chip (1) in boundary regions with a ferromagnetic layer (23).

8. Current sensor according to any of claims 1 to 7, **characterized in that** the semiconductor chip (1) is with a ferromagnetic layer (24) on the side remote from the current conductor (3).

9. Current sensor according to any of claims 1 to 8, **characterized in that** the housing (7) is a QFN housing and **in that** only the electrical terminals of the current sensor are exposed at the underside of the QFN housing.

10. Current sensor according to any of claims 1 to 9, **characterized in that** the at least one magnetic field sensor (2) comprises two magnetic field sensors or clusters of magnetic field sensors, which are arranged in the area of a central section of the current conductor (3) at different edges of the current conductor (3), so that the magnetic field produced by the current flowing through the current conductor (3) points in opposite directions at the location of the two magnetic field sensors (2).

## Revendications

1. Capteur de courant, comprenant
un boîtier en plastique (7),
un conducteur de courant (3) avec des premières et deuxièmes connexions électriques (4, 5) formées intégralement, par lesquelles un courant à mesurer est fourni et déchargé,
des troisièmes connexions électriques (6),
une puce semi-conductrice (1) ayant une surface active avec au moins un capteur de champ magnétique (2) qui est sensible à une composante du champ magnétique généré par le courant circulant à travers le conducteur de courant (3), laquelle composante étant perpendiculaire à la surface active de la puce semi-conductrice (1),
les premières et deuxièmes connexions électriques (4, 5) étant disposées sur un premier côté du boîtier (7) et les troisièmes connexions électriques (6) étant disposées sur un côté du boîtier (7) opposé au premier côté,
la surface active de la puce semi-conductrice (1) étant tournée vers le conducteur de courant (3) et des surfaces de connexion électrique (13) de la puce semi-conductrice (1) étant reliées aux troisièmes connexions électriques (6) par des premières bosses (8),
**caractérisé en ce que**
le conducteur de courant (3) est en forme de U, le U étant formé de trois sections, à savoir une première section comprenant les premières connexions électriques (4), une deuxième section allongée avec des bords parallèles (12) et une troisième section comprenant les deuxièmes connexions électriques (5), le conducteur de courant (3) ayant une largeur relativement grande sur toute sa longueur pour réduire sa résistance électrique à une valeur minimale possible,
**en ce que** la puce semi-conductrice (1) est disposée à peu près symétriquement par rapport à un axe longitudinal du conducteur de courant (3) dans la deuxième section, et
**en ce que** la puce semi-conductrice (1) comporte des secondes bosses (9) isolées électriquement de la surface active de la puce semi-conductrice (1) par une couche isolante (10) et reposant sur le conducteur de courant (3) ou sur des prolongements formés sur le conducteur de courant (3).

2. Capteur de courant selon la revendication 1, **caractérisé en ce que** les extrémités des troisièmes connexions électriques (6) qui se trouvent au-dessus de la puce semi-conductrice (1) sont disposées essentiellement le long d'une ligne (11), et **en ce qu'**un bord adjacent (12) du conducteur de courant (3) s'étend parallèlement à la ligne (11), de sorte que toutes les troisièmes connexions électriques (6) se trouvent à peu près à la même distance (A) du conducteur de courant (3).

3. Capteur de courant selon la revendication 1 ou 2, **caractérisé en ce que** le conducteur de courant (3) comporte au moins deux prolongements (16) qui s'étendent jusqu'au bord du boîtier (7) et y sont exposés.

4. Capteur de courant selon l'une des revendications 1 à 3, **caractérisé en ce que** la couche isolante (10) comprend une couche de matière organique.

5. Capteur de courant selon la revendication 4, **caractérisé en ce que** la matière organique est du polyimide.

6. Capteur de courant selon l'une des revendications 1 à 5, **caractérisé en ce qu'**aucune structure électriquement conductrice constituée d'une couche de métallisation présente pour la production de connexions électriques n'est présente entre la surface du matériau de base de la puce semi-conductrice (1) et les deuxièmes bosses (9).

7. Capteur de courant selon l'une des revendications 1 à 6, **caractérisé en ce que** le conducteur de courant (3) est recouvert d'une couche ferromagnétique (23) complètement sur trois côtés et sur le côté opposé à la puce semi-conductrice (1) dans des zones de bordure.

8. Capteur de courant selon l'une des revendications 1 à 7, **caractérisé en ce que** la puce semi-conductrice (1) est avec une couche ferromagnétique (24) sur le côté opposé au conducteur de courant (3).

9. Capteur de courant selon l'une des revendications 1 à 8, **caractérisé en ce que** le boîtier (7) est un boîtier QFN et que seules les connexions électriques du capteur de courant sont exposées au fond du boîtier QFN.

10. Capteur de courant selon l'une des revendications 1 à 9, **caractérisé en ce que** le au moins un capteur de champ magnétique (2) comprend deux capteurs de champ magnétique ou groupes de capteurs de champ magnétique disposés dans la région d'une partie centrale du conducteur de courant (3) sur différents bords du conducteur de courant (3) de sorte que le champ magnétique généré par le courant circulant à travers le conducteur de courant (3) est dirigé dans des directions opposées à l'emplacement des deux capteurs de champ magnétique (2).
